# EUROPEAN PATENT APPLICATION

(11) **EP 4 848 916 A1**
(43) Date of publication of application: **02.12.2026**
(21) Application number: 24920388.6
(22) Date of filing: 22.01.2024
(51) Int. Cl.: H05K 7/20, G06F 1/20, H01L 23/473

(54) **ELECTRONIC CONTROL DEVICE**

(71) Applicant: Astemo, Ltd., Chiyoda-ku, Tokyo 1000004 (JP)
(72) Inventor: FUKUDA, Tomohiro, Hitachinaka-shi, Ibaraki 312-8503 (JP); CHIU Eric, New Taipei City, 23511 (TW)
(74) Representative: MERH-IP Matias Erny Reichl Hoffmann Patentanwälte PartG mbB
(86) International application number: PCT/JP2024/001649
(87) International publication number: WO 2025/158496

(57) **Abstract**

An electronic control device includes a housing having a main body portion in which a cooling water flow path through which cooling water passes is formed, a first circuit board, a second circuit board, and a connector. The first circuit board is disposed in the housing, and an electronic component facing the cooling water flow path is mounted on the first circuit board. The second circuit board is disposed on a side of the housing opposite to the first circuit board, and an electronic component facing the cooling water flow path is mounted on the second circuit board. The connector electrically connects the first circuit board and the second circuit board. A through opening through which the connector is inserted is formed in the main body portion of the housing. Then, the through opening is disposed within a projected plane of the cooling water flow path when the housing is viewed from a direction orthogonal to a direction in which the first circuit board and the second circuit board face each other.

## Description

### Technical Field

The present invention relates to an electronic control device.

### Background Art

In recent years, an amount of heat generation of electronic components mounted on circuit boards has been increasing. Therefore, conventionally, as a method for cooling electronic components mounted on a plurality of circuit boards, a water-cooling type cooling method using cooling water has been proposed. As a conventional electronic control device of this type, for example, an electronic control device such as that described in PTL 1 is available.

PTL 1 describes a technique including a box-shaped housing, at least a pair of mounting boards disposed in the housing and mounted with electric elements, and a cooling body having a flow path through which a cooling medium flows. Then, PTL 1 describes that each mounting board is a double-sided mounting type board, and a first heat-generating element mounted on a first mounting surface facing the cooling body side is thermally connected to the cooling body. Then, a second heat-generating element mounted on a second mounting surface located on a side opposite to the cooling body is thermally connected to the housing.

### Citation List

### Patent Literature

PTL 1: JP 2021-180250 A

### Summary of Invention

### Technical Problem

However, in the technique described in PTL 1, a connector that electrically connects two circuit boards is disposed at a position separated from a cooling water flow path through which cooling water flows, the cooling water flow path being disposed between the two circuit boards. As a result, the technique described in PTL 1 has a problem in that a distance between the connector and the electronic component, which is a heat-generating component, is increased, and a wiring distance for connecting the connector and the electronic component is increased.

This object is to provide an electronic control device that, in consideration of the above problems, can shorten a wiring distance between an electronic component, which is a heat-generating component, and a connector.

### Solution to Problem

To solve the above problem and achieve the object, the electronic control device includes a housing having a main body portion in which a cooling water flow path through which cooling water passes is formed, a first circuit board, a second circuit board, and a connector. The first circuit board is disposed in the housing, and an electronic component facing the cooling water flow path is mounted on the first circuit board. The second circuit board is disposed on a side of the housing opposite to the first circuit board, and an electronic component facing the cooling water flow path is mounted on the second circuit board. The connector electrically connects the first circuit board and the second circuit board. A through opening is formed in the main body portion of the housing, the through opening penetrating the housing in a direction orthogonal to a direction in which the first circuit board and the second circuit board face each other and allowing the connector to be inserted therethrough. Then, the through opening is disposed within a projected plane of the cooling water flow path when the housing is viewed from the direction orthogonal to the direction in which the first circuit board and the second circuit board face each other.

### Advantageous Effects of Invention

According to the electronic control device having the above configuration, a wiring distance between an electronic component, which is a heat-generating component, and a connector can be shortened.

### Brief Description of Drawings

[FIG. 1] FIG. 1 is an exploded perspective view illustrating an electronic control device according to a first embodiment example.
[FIG. 2] FIG. 2 is a perspective view illustrating a housing of the electronic control device according to the first embodiment example.
[FIG. 3] FIG. 3 is a plan view illustrating the electronic control device according to the first embodiment example.
[FIG. 4] FIG. 4 is a cross-sectional view illustrating the electronic control device according to the first embodiment example.
[FIG. 5] FIG. 5 is a plan view illustrating an electronic control device according to a second embodiment example.
[FIG. 6] FIG. 6 is a plan view illustrating a housing of an electronic control device according to a third embodiment example.
[FIG. 7] FIG. 7 is a cross-sectional view illustrating the electronic control device according to the third embodiment example.

### Description of Embodiments

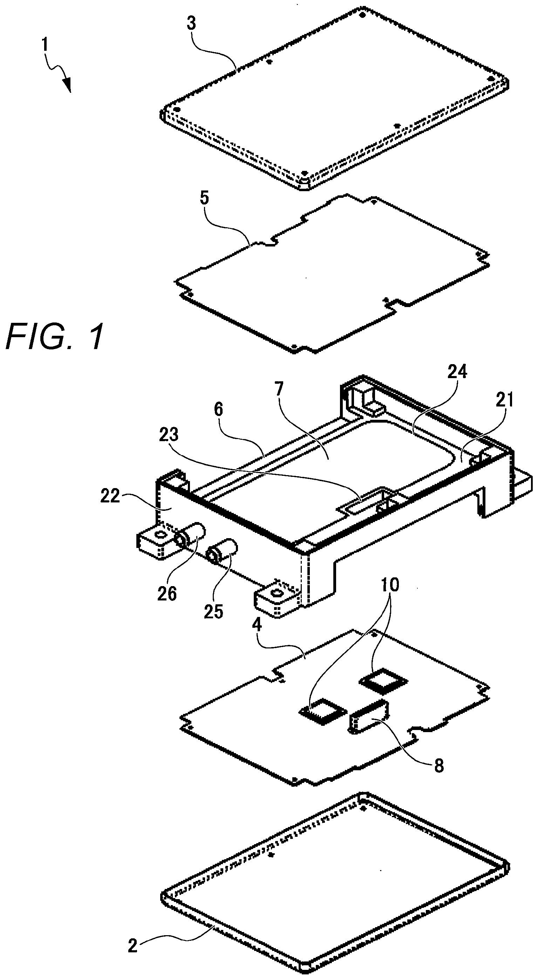

Hereinafter, embodiment examples of an electronic control device will be described with reference to FIGS. 1 to 7. In each drawing, common members are denoted by the same reference signs.

### 1. First Embodiment Example

First, a configuration of an electronic control device according to a first embodiment example (hereinafter referred to as the "present example") will be described with reference to FIGS. 1 to 4.

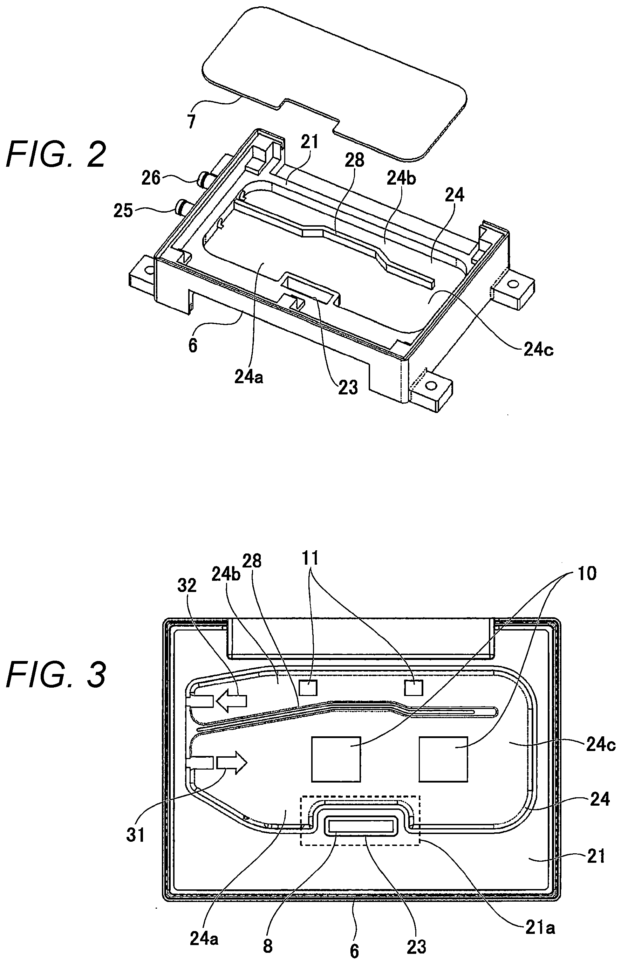

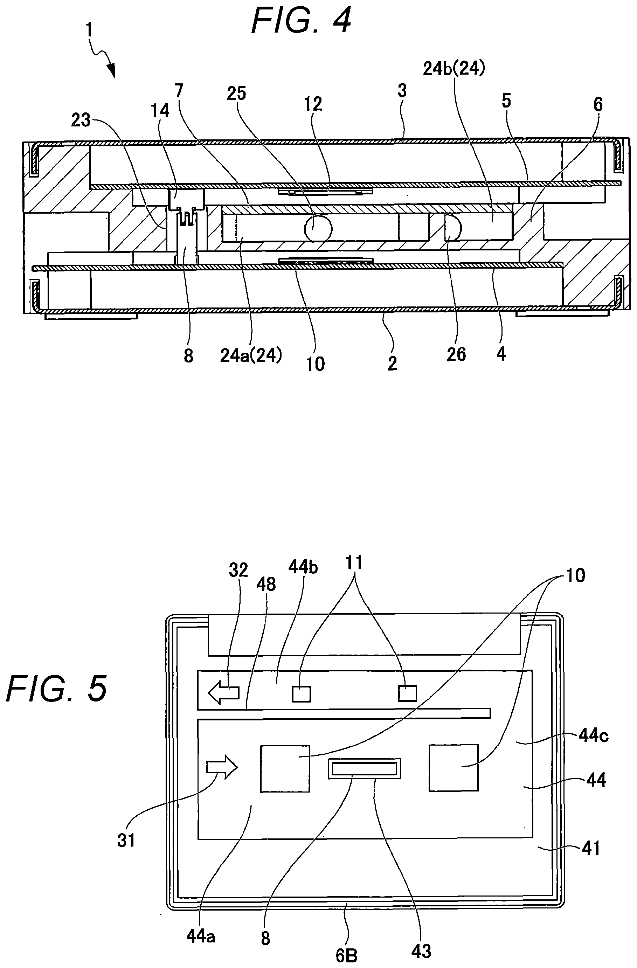

FIG. 1 is an exploded perspective view illustrating the electronic control device, and FIG. 2 is a perspective view illustrating a housing of the electronic control device. FIG. 3 is a plan view illustrating the electronic control device, and FIG. 4 is a cross-sectional view illustrating the electronic control device.

An electronic control device 1 illustrated in FIGS. 1 to 4 is, for example, an electronic control device that is mounted in an automobile and has an electronic circuit for controlling the automobile. As illustrated in FIGS. 1 to 4, the electronic control device 1 includes a first cover 2, a second cover 3, a first circuit board 4 and a second circuit board 5, and a housing 6 formed in a substantially rectangular shape.

The first cover 2 and the second cover 3 are formed in a substantially flat plate shape. The first cover 2 is disposed to face one surface of the housing 6, and the second cover 3 is disposed to face another surface on a side opposite to the one surface of the housing 6. The first cover 2 and the second cover 3 are fixed to the housing 6.

The first circuit board 4 is disposed on one surface side of the housing 6, and the second circuit board 5 is disposed on another surface side of the housing 6. Then, the first circuit board 4 is accommodated in a space formed between the housing 6 and the first cover 2. In addition, the second circuit board 5 is accommodated in a space formed between the housing 6 and the second cover 3.

A plurality of first electronic components 10, which are heat-generating components, and a second electronic component 11 are mounted on the first circuit board 4. For example, a system on chip (SOC) or the like is applied as the first electronic component 10. In addition, the second electronic component 11 is an electronic component having a smaller amount of heat generation than the first electronic component 10, and, for example, a capacitor or the like is applied. In addition, the first circuit board 4 is provided with a connector 8 for electrical connection to a connector 14 provided on the second circuit board 5. The connector 8 protrudes perpendicularly from one surface of the first circuit board 4 toward the second circuit board 5. Also on the second circuit board 5, similarly to the first circuit board 4, a plurality of third electronic components 12, which are heat-generating components, are mounted.

Next, the housing 6 in which the above-described first circuit board 4 and second circuit board 5 are disposed will be described.

The housing 6 is formed in a rectangular parallelepiped shape having a substantially rectangular shape. The housing 6 has a hollow main body portion 21 and a side wall portion 22. The side wall portion 22 is formed so as to surround the periphery of the main body portion 21. In addition, the side wall portion 22 is connected substantially perpendicularly to the main body portion 21. The first cover 2 is fixed to one end portion of the side wall portion 22. In addition, the second cover 3 is fixed to another end portion of the side wall portion 22.

A cooling water inflow portion 25 and a cooling water discharge portion 26 are provided in the side wall portion 22 disposed at one end portion in a longitudinal direction of the main body portion 21. The cooling water inflow portion 25 and the cooling water discharge portion 26 communicate with a cooling water flow path 24 formed in the main body portion 21 described later. The cooling water inflow portion 25 is disposed on one side in a short-side direction of the main body portion 21, and the cooling water discharge portion 26 is disposed on another side in the short-side direction of the main body portion 21. Cooling water is fed into the cooling water inflow portion 25 from a pump (not illustrated). Then, cooling water flows into the cooling water flow path 24 via the cooling water inflow portion 25. In addition, cooling water that has passed through the cooling water flow path 24 is discharged to the outside from the cooling water discharge portion 26.

The first circuit board 4 is disposed between the first cover 2 and the main body portion 21. In addition, the second circuit board 5 is disposed between the second cover 3 and the main body portion 21. The first circuit board 4 is disposed to face one surface of the main body portion 21 facing the first cover 2. Furthermore, the second circuit board 5 is disposed to face another surface of the main body portion 21 facing the second cover 3.

In addition, as illustrated in FIG. 2, a through opening 23 and the cooling water flow path 24 are formed in the main body portion 21. The cooling water flow path 24 is a recessed portion recessed from the other surface of the main body portion 21 toward the one surface. Therefore, a surface of the cooling water flow path 24 on the second cover 3 and second circuit board 5 side is open. In addition, as illustrated in FIGS. 1 and 4, a lid 7 having a substantially flat plate shape is fixed to the main body portion 21. The lid 7 is fixed to the main body portion 21 and closes an opening of the cooling water flow path 24 on the second circuit board 5 side.

Cooling water is fed into the cooling water flow path 24 via the cooling water inflow portion 25. Then, the cooling water flow path 24 serves as a heat dissipation destination for the first electronic component 10 and the third electronic component 12, which are heat-generating components.

Furthermore, as illustrated in FIGS. 2 and 3, a partition portion 28 is formed in the cooling water flow path 24. The partition portion 28 protrudes substantially perpendicularly from a bottom surface of the cooling water flow path 24 toward the opening on the second circuit board 5 side. In addition, the partition portion 28 is a projecting strip extending by a predetermined length along the longitudinal direction from one end portion in the longitudinal direction of the cooling water flow path 24. Furthermore, the partition portion 28 is formed offset to one side from an intermediate portion in the short-side direction of the cooling water flow path 24.

Then, an upstream portion 24a, a downstream portion 24b, and a turn-back portion 24c are formed in the cooling water flow path 24 by the partition portion 28. The upstream portion 24a is formed on one side in the short-side direction with respect to the partition portion 28 in the cooling water flow path 24. The upstream portion 24a communicates with the cooling water inflow portion 25. The downstream portion 24b is formed on another side in the short-side direction with respect to the partition portion 28 in the cooling water flow path 24. The downstream portion 24b communicates with the cooling water discharge portion 26.

As described above, the partition portion 28 is formed offset to one side from the intermediate portion in the short-side direction of the cooling water flow path 24. Therefore, in the cooling water flow path 24, a flow path width of the upstream portion 24a is formed to be larger than a flow path width of the downstream portion 24b. That is, a cooling space of the upstream portion 24a in the cooling water flow path 24 is wider than a cooling space of the downstream portion 24b. Accordingly, cooling performance in the upstream portion 24a in the cooling water flow path 24 can be made higher than in the downstream portion 24b.

The upstream portion 24a and the downstream portion 24b are connected to the turn-back portion 24c at another end portion in the longitudinal direction of the cooling water flow path 24. Cooling water that has flowed in from the cooling water inflow portion 25 moves along the upstream portion 24a from one end portion toward another end portion in the longitudinal direction of the cooling water flow path 24. Cooling water that has reached the turn-back portion 24c has its traveling direction turned back by the turn-back portion 24c from the other end portion toward the one end portion in the longitudinal direction of the cooling water flow path 24. Then, the cooling water moves along the downstream portion 24b from the other end portion toward the one end portion in the longitudinal direction of the cooling water flow path 24 and is discharged to the outside from the cooling water discharge portion 26.

As illustrated in FIGS. 3 and 4, the upstream portion 24a in the cooling water flow path 24 is formed to face the first electronic component 10, which has a large amount of heat generation, on the first circuit board 4. Note that the upstream portion 24a is also formed to face the third electronic component 12, which has a large amount of heat generation, on the second circuit board 5. Then, the downstream portion 24b in the cooling water flow path 24 is formed to face the second electronic component 11, which has a small amount of heat generation, on the first circuit board 4. In this manner, by disposing the upstream portion 24a in the cooling water flow path 24 so as to face the first electronic component 10 and the third electronic component 12, which are heat-generating components, cooling efficiency can be increased. Furthermore, because a flow path volume of the upstream portion 24a is larger than a flow path volume of the downstream portion 24b, the first electronic component 10 and the third electronic component 12, which are heat-generating components, can be cooled more efficiently.

In addition, as illustrated in FIG. 3, a protruding portion 21a is formed in the main body portion 21. The protruding portion 21a is formed so as to protrude from an outer edge portion on a long side of the cooling water flow path 24 toward an inner side in the short-side direction. The protruding portion 21a is formed in the cooling water flow path 24 when the main body portion 21 is viewed from a direction facing the second cover 3. Then, the through opening 23 is formed in the protruding portion 21a.

The through opening 23 is a through hole continuously formed from the one surface to the other surface in the main body portion 21. As illustrated in FIG. 4, the through opening 23 is disposed within a projected plane of the cooling water flow path 24 when the housing 6 is viewed from the short-side direction and the longitudinal direction, which are directions orthogonal to the direction in which the first circuit board 4 and the second circuit board 5 face each other. In addition, the protruding portion 21a is formed in the cooling water flow path 24 when the main body portion 21 is viewed from the direction facing the second cover 3.

The connector 8 provided on the first circuit board 4 is inserted through the through opening 23. Furthermore, the through opening 23 faces the connector 14 provided on the second circuit board 5. In addition, a notch is formed in a portion of the lid 7 facing the through opening 23. Accordingly, the connector 8 of the first circuit board 4 can be connected to the connector 14 of the second circuit board 5 via the through opening 23.

In addition, by forming the through opening 23 on the cooling water flow path 24, the connectors 8 and 14 are disposed close to the first electronic component 10 and the third electronic component 12 facing the cooling water flow path 24. Accordingly, according to the electronic control device 1 of the present example, the connectors 8 and 14 can be mounted closer to the first electronic component 10 and the third electronic component 12 than in a conventional electronic control device in which the connectors 8 and 14 are disposed at locations separated from the cooling water flow path 24. As a result, a wiring distance between the connector 8 and the first electronic component 10 can be shortened.

By shortening the wiring distance between the connector 8 and the first electronic component 10, a margin occurs in transmission loss. Therefore, an amount corresponding to the length of wiring shortened between the connector 8 and the first electronic component 10 can be replaced with a length in a height direction in which the connector 8 protrudes from the first circuit board 4. That is, according to the electronic control device 1 of the present example, the connector 8 taller than a connector in a conventional electronic control device can be used.

By increasing the height of the connector 8, a thickness of the main body portion 21 through which the connector 8 penetrates can also be increased. Accordingly, a length in a height direction, which is a direction facing the first circuit board 4 or the second circuit board 5, in the cooling water flow path 24 formed in the main body portion 21 can be increased. As a result, according to the electronic control device 1 of the present example, the volume of the entire cooling water flow path 24 can be increased, and cooling performance can be improved.

### 2. Second Embodiment Example

Next, an electronic control device according to a second embodiment example will be described with reference to FIG. 5.

FIG. 5 is a plan view illustrating the electronic control device according to the second embodiment example.

A point in which the electronic control device according to the second embodiment example differs from the electronic control device 1 according to the first embodiment example is a position at which a through opening through which the connector 8 is inserted is provided. Therefore, here, portions common to the electronic control device 1 according to the first embodiment example are denoted by the same reference signs, and duplicate description will be omitted.

As illustrated in FIG. 5, the electronic control device according to the second embodiment example includes a housing 6B in which a cooling water flow path 44 is formed in a main body portion 41. In the cooling water flow path 44, an upstream portion 44a that serves as an upstream region 31 of a flow path of cooling water, a downstream portion 44b that serves as a downstream region 32, and a turn-back portion 44c are formed by a partition portion 48. The upstream portion 44a of the cooling water flow path 44 is disposed to face the first electronic component 10, which is a heat-generating component. In addition, he downstream portion 44b of the cooling water flow path 44 is disposed to face the second electronic component 11, which has a small amount of heat generation.

Furthermore, a cylindrical partition wall portion 43 is formed in the upstream portion 44a of the cooling water flow path 44. The partition wall portion 43 protrudes substantially perpendicularly from a bottom surface of the cooling water flow path 44 toward an opening on the second circuit board 5 side. That is, the partition wall portion 43 protrudes in a direction facing the first circuit board 4 and the second circuit board 5. Then, an end portion of a cylindrical hole of the partition wall portion 43 on the bottom surface side of the cooling water flow path 44 is open. Therefore, the cylindrical hole of the partition wall portion 43 serves as a through opening penetrating the main body portion 21. Then, the connector 8 is inserted through the cylindrical hole of the partition wall portion 43. Note that an opening through which the connector 8 is inserted is formed in a portion of a lid (not illustrated), facing the cylindrical hole of the partition wall portion 43.

In this manner, according to the electronic control device according to the second embodiment example, similarly to the electronic control device 1 according to the first embodiment example, the through opening through which the connector 8 is inserted is formed in the cooling water flow path 44 facing the first electronic component 10. Accordingly, according to the electronic control device according to the second embodiment example, a wiring distance between the connector 8 and the first electronic component 10 can be shortened.

Other configurations are the same as those of the electronic control device 1 according to the first embodiment, and therefore description of the other configurations will be omitted. Also with the electronic control device having the housing 6B as described above, effects similar to those of the electronic control device 1 according to the first embodiment example described above can be obtained.

### 3. Third Embodiment Example

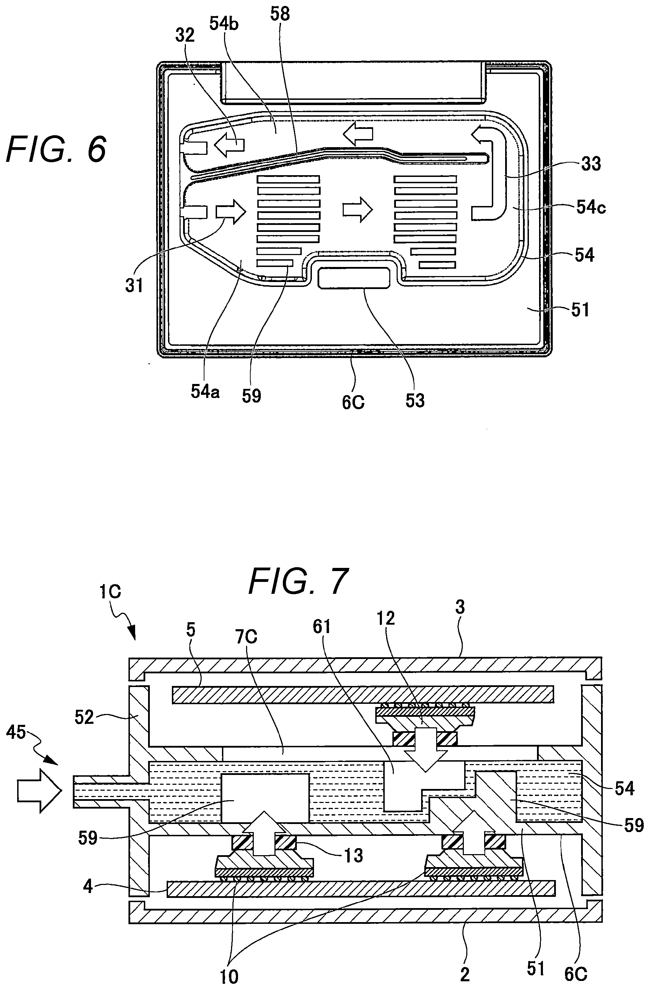

Next, an electronic control device according to a third embodiment example will be described with reference to FIGS. 6 and 7.

FIG. 6 is a plan view illustrating a housing of the electronic control device according to the third embodiment example, and FIG. 7 is a cross-sectional view illustrating the electronic control device according to the third embodiment example.

A point in which the electronic control device according to the third embodiment example differs from the electronic control device 1 according to the first embodiment example is that heat dissipation fins are provided in a cooling water flow path. Therefore, here, a protective member will be described, and portions common to the electronic control device 1 according to the first embodiment example are denoted by the same reference signs, and duplicate description will be omitted.

As illustrated in FIGS. 6 and 7, an electronic control device 1C includes the first cover 2, the second cover 3, the first circuit board 4 and the second circuit board 5 on which an electronic component 10 is mounted, a housing 6C, and a lid 7C. Heat dissipation grease 13 is interposed between the first electronic component 10 mounted on the first circuit board 4 and one surface of a main body portion 51 of the housing 6C. In addition, the heat dissipation grease 13 is also interposed between the third electronic component 12 mounted on the second circuit board 5 and the lid 7C.

A cooling water flow path 54 is formed in the main body portion 51 of the housing 6C. In the cooling water flow path 54, an upstream portion 54a that serves as the upstream region 31 of a flow path of cooling water, a downstream portion 54b that serves as the downstream region 32, and a turn-back portion 54c that serves as a turn-back point 33 are formed by a partition portion 58. The upstream portion 54a of the cooling water flow path 54 is disposed to face the first electronic component 10, which is a heat-generating component. In addition, the upstream portion 54a communicates with a cooling water inflow portion 45 provided in a side wall portion 52 of the housing 6C.

In addition, a plurality of heat dissipation fins 59 are provided in the upstream portion 54a. The plurality of heat dissipation fins 59 protrude substantially perpendicularly from a bottom surface of the cooling water flow path 54 in a direction facing the second cover 3. In addition, the plurality of heat dissipation fins 59 extend along a longitudinal direction of the main body portion 51, which is a direction in which cooling water flows. Then, the plurality of heat dissipation fins 59 are disposed at intervals in a short-side direction of the main body portion 51. Furthermore, the plurality of heat dissipation fins 59 are disposed at portions of the upstream portion 54a facing the first electronic component 10.

In addition, a plurality of heat dissipation fins 61 are provided on an opposing surface of the lid 7C that faces the cooling water flow path 54. The plurality of heat dissipation fins 61 protrude substantially perpendicularly from the opposing surface of the lid 7C toward the cooling water flow path 54. In addition, the plurality of heat dissipation fins 61 extend along the longitudinal direction of the main body portion 51, which is the direction in which cooling water flows. Then, the plurality of heat dissipation fins 61 are disposed at intervals in a short-side direction of the lid 7C. Furthermore, the plurality of heat dissipation fins 61 are disposed at portions of the lid 7C facing the third electronic component 12.

In this manner, by providing the plurality of heat dissipation fins 59 and 61, heat from the first electronic component 10 and the third electronic component 12 can be efficiently transferred to cooling water flowing through the cooling water flow path 54.

Here, in the cooling water flow path 54, a flow path width of the upstream portion 54a is formed to be larger than a flow path width of the downstream portion 54b. Therefore, cooling performance of the upstream portion 54a can be made higher than cooling performance of the downstream portion 54b. Note that by increasing the flow path width, the upstream portion 54a has a smaller pressure loss than the downstream portion 54b.

In contrast, in the electronic control device 1C according to the third embodiment example, the plurality of heat dissipation fins 59 and 61 are disposed in the upstream portion 54a having a large flow path width at intervals in a direction orthogonal to the direction in which cooling water flows. With the plurality of heat dissipation fins 59 and 61, pressure loss in the upstream portion 54a of the cooling water flow path 54 and pressure loss in the downstream portion 54b can be equalized. As a result, the first electronic component 10 and the third electronic component 12, which are heat-generating components, can be efficiently cooled.

Other configurations are the same as those of the electronic control device 1 according to the first embodiment, and therefore description of the other configurations will be omitted. Also with the electronic control device 1C according to the third embodiment example, effects similar to those of the electronic control device 1 according to the first embodiment example described above can be obtained.

Note that the present invention is not limited to the embodiments described above and illustrated in the drawings, and various modifications can be made within a scope not departing from the gist of the invention described in the claims. In addition, a part of a configuration of one embodiment example can be replaced with a configuration of another embodiment example, and a configuration of another embodiment example can also be added to a configuration of one embodiment example. Furthermore, addition, deletion, or replacement of another configuration can be made with respect to a part of a configuration of another embodiment example.

Note that in the embodiment examples described above, the example in which the number of connectors that electrically connect the first circuit board 4 and the second circuit board 5 is one has been described; however, the present invention is not limited to this example, and the first circuit board 4 and the second circuit board 5 may be connected by a plurality of connectors. In this case, a through hole through which at least one connector among the plurality of connectors is inserted may be formed in the cooling water flow path.

In addition, the number of the first circuit board 4 and the number of the second circuit board 5 are not limited to one board each, and a plurality of the first circuit boards 4 and a plurality of the second circuit boards 5 may be provided.

Note that in the present specification, terms such as "parallel" and "orthogonal" have been used; however, these terms do not mean only strict "parallel" and "orthogonal", and may include states of "substantially parallel" and "substantially orthogonal" that include "parallel" and "orthogonal" and are further within a range in which the functions can be exhibited.

### Reference Signs List

1, 1C electronic control device
2 first cover
3 second cover
4 first circuit board
5 second circuit board
6, 6B, 6C housing
7, 7C lid
8, 14 connector
10 first electronic component (heat-generating component)
11 second electronic component
12 third electronic component (heat-generating component)
13 heat dissipation grease
21, 41, 51 main body portion
21a protruding portion
22, 52 side wall portion
23 through opening
24, 44, 54 cooling water flow path
24a, 44a, 54a upstream portion
24b, 44b, 54b downstream portion
24c, 44c, 54c turn-back portion
25, 45 cooling water inflow portion
26 cooling water discharge portion
28, 48, 58 partition portion
31 upstream region
32 downstream region
33 turn-back point
43 partition wall portion
59, 61 heat dissipation fin

## Claims

1. An electronic control device comprising:
a housing having a main body portion in which a cooling water flow path through which cooling water passes is formed;
a first circuit board disposed in the housing and mounted with an electronic component facing the cooling water flow path;
a second circuit board disposed on a side of the housing opposite to the first circuit board and mounted with an electronic component facing the cooling water flow path; and
a connector electrically connecting the first circuit board and the second circuit board,
wherein a through opening is formed in the main body portion of the housing, the through opening penetrating the housing in a direction orthogonal to a direction in which the first circuit board and the second circuit board face each other and allowing the connector to be inserted therethrough; and
wherein the through opening is disposed within a projected plane of the cooling water flow path when the housing is viewed from the direction orthogonal to the direction in which the first circuit board and the second circuit board face each other.

2. The electronic control device according to claim 1, wherein the main body portion is formed with a protruding portion in which the through opening is formed,
and the protruding portion is formed so as to protrude toward an inside of the cooling water flow path.

3. The electronic control device according to claim 1, wherein a partition wall portion protruding in a direction in which the first circuit board and the second circuit board face each other is formed inside the cooling water flow path,
the partition wall portion is formed in a cylindrical shape, and a cylindrical hole penetrates the main body portion,
and the cylindrical hole of the partition wall portion serves as the through opening through which the connector is inserted.

4. The electronic control device according to claim 1, wherein the cooling water flow path has an upstream portion on an upstream side in a direction in which the cooling water flows,
and a downstream portion on a downstream side in the direction in which the cooling water flows,
and the upstream portion faces a heat-generating component that generates heat among a plurality of electronic components mounted on the first circuit board and the second circuit board.

5. The electronic control device according to claim 4, wherein a flow path width of the upstream portion in the cooling water flow path is formed to be larger than a flow path width of the downstream portion.

6. The electronic control device according to claim 1, wherein the cooling water flow path is a recessed portion formed in the main body portion,
the electronic control device further comprising a lid that closes an opening of the recessed portion.
